# EUROPEAN PATENT APPLICATION

(11) **EP 4 561 283 A1**
(43) Date of publication of application: **28.05.2025**
(21) Application number: 24818465.7
(22) Date of filing: 16.05.2024
(51) Int. Cl.: H05K 7/20, F28D 15/02

(54) **HEAT DISSIPATION FIN, THERMOSYPHON HEATSINK AND MULTI-DIMENSIONAL HEAT DISSIPATION DEVICE**

(30) Priority: 07.06.2023 CN 202310674134
(71) Applicant: Guangdong Envicool Technology Co., Ltd., Sanjiao Town, Zhongshan Guangdong 528400 (CN)
(72) Inventor: TU, Yijian, Zhongshan, Guangdong 528400 (CN); ZHANG, Jing, Zhongshan, Guangdong 528400 (CN)
(74) Representative: Torggler & Hofmann Patentanwälte - Innsbruck
(86) International application number: PCT/CN2024/093612
(87) International publication number: WO 2024/250932

(57) **Abstract**

A heat dissipation fin, a thermosyphon heatsink and a multi-dimensional heat dissipation device, relating to the technical field of electronic heat dissipation. The heat dissipation fin comprises: a shell, a gas inlet and a liquid outlet which are provided on the shell, and a gas-liquid cavity which is provided in the shell, wherein the gas inlet is configured for connecting the gas-liquid cavity to an accommodating cavity in a heat dissipation substrate of a thermosyphon heatsink; the liquid outlet is configured for connecting the gas-liquid cavity to the accommodating cavity; and the height of the gas inlet in a vertical direction is greater than the height of the liquid outlet. The gas-liquid cavity comprises: a first flow guide portion, which is configured for guiding gas to flow and is in communication with the gas inlet; a second flow guide portion, which is configured for guiding liquid to flow and is in communication with the liquid outlet; and a connecting portion, which is in communication with both the first flow guide portion and the second flow guide portion, wherein the included angle between the first flow guide portion and the connecting portion, and the included angle between the connecting portion and the second flow guide portion are both obtuse angles. The present invention can alleviate the problem of poor circulation of a working medium in the prior art, and can improve the heat dissipation performance of a heatsink.

## Description

The present application claims the priority to Chinese Patent Application No. 202310674134.0, titled "HEAT DISSIPATION FIN, THERMOSYPHON HEATSINK AND MULTI-DIMENSIONAL HEAT DISSIPATION DEVICE", filed with the China National Intellectual Property Administration on June 7, 2023, the entire disclosure of which is incorporated herein by reference.

### FIELD

The present application relates to the technical field of heat dissipation of electronics, and in particular to a heat dissipation fin, and a thermosiphon heatsink and a multi-dimensional heat dissipation device that include the heat dissipation fin.

### BACKGROUND

In the related art, a heatsink based on thermosiphon principle is used for heat dissipation of electronic devices with high power consumption. This type of heatsink includes a heat dissipation substrate and a heat dissipation fin connected to the heat dissipation substrate. The heat dissipation substrate and the heat dissipation fin are both provided with cavities in communication with each other, and, a phase-change working medium is circulated between the cavities thereof when dissipating a heat from the electronic device. In this way, the heat of the electronic device is dissipated based on phase-change heat exchange.

During implementation of the present application, at least the following problem is found in the conventional technology.

The heat dissipation fin lacks a guiding structure for the working medium, and the flow of working medium suffers a relatively high resistance, causing poor circulation of the working medium, and thus affecting the heat dissipation performance of the heatsink.

In view of the above, it is now desired for those skilled in the art to solve the problem of the poor circulation of the working medium so as to improve the heat dissipation performance of the heatsink.

### SUMMARY

**In** view of this, an object of the present application is to provide a heat dissipation fin, which can solve the problem of poor circulation of a working medium in the conventional technology to improve the heat dissipation performance of a heatsink.

Another object of the present application is to provide a thermosiphon heatsink and a multi-dimensional heat dissipation device that include the heat dissipation fin.

To achieve the above objects, the following technical solutions are provided according to the present application.

In a first aspect, provided herein is a multi-dimensional heat dissipation device for base state communication, applied to a thermosiphon heatsink. A heat dissipation fin includes a shell, a gas inlet and a liquid outlet that are provided in the shell, and a gas-liquid cavity that is provided inside the shell.

The gas inlet is configured to communicate the gas-liquid cavity with an accommodating cavity inside a heat dissipation substrate of the thermosiphon heatsink, to allow a gas inside the accommodating cavity to flow into the gas-liquid cavity.

The liquid outlet is configured to communicate the gas-liquid cavity with the accommodating cavity, to allow a liquid inside the gas-liquid cavity to flow into the accommodating cavity.

The gas inlet is located above the liquid outlet in a vertical direction.

The gas-liquid cavity includes a first flow guide portion, a second flow guide portion, and a connecting portion.

The first flow guide portion is configured to guide flow of the gas, and is in communication with the gas inlet.

The second flow guide portion is configured to guide flow of the iquid, and is in communication with the liquid outlet.

The connecting portion is in communication with the first flow guide portion and the second flow guide portion.

An angle between the first flow guide portion and the connecting portion, and an angle between the connecting portion and the second flow guide portion are both obtuse angles.

In a possible implementation, a third flow guide portion is provided at the gas inlet and configured to guide flow of the gas, and a fourth flow guide portion is provided at the liquid outlet and configured to guide flow of the liquid.

In a possible implementation, a plurality of first support members are provided inside the gas-liquid cavity, and two opposite ends of each of the plurality of first support members are connected to the shell. Each first support member is provided with a guiding surface.

In a possible implementation, the shell is provided with at least two gas inlets, or the shell is provided with a single gas inlet and a single liquid outlet.

In a possible implementation, the gas inlet and the liquid outlet are provided at a same side.

In a second aspect, provided herein is a thermosiphon heatsink including a heat dissipation substrate, and the heat dissipation fin according to any one of solutions in the first aspect.

An accommodating cavity is provided inside the heat dissipation substrate, and is configured to accommodate a phase-change working medium.

The heat dissipation fin is connected to the heat dissipation substrate.

The accommodating cavity is in communication with the gas inlet and the liquid outlet.

In a possible implementation, a plurality of second support members are provided inside the accommodating cavity, and two opposite ends of each of the plurality of second support members are connected to the heat dissipation substrate. The plurality of second support members are distributed in a staggered manner.

In a third aspect, provided herein is a multi-dimensional heat dissipation device including the heat dissipation substrate and the heat dissipation fin according to any one of the solutions in the second aspect, and an auxiliary heat dissipation member that is provided at a side of the heat dissipation fin away from the heat dissipation substrate. An auxiliary heat dissipation cavity is provided inside the auxiliary heat dissipation member, and is in communication with the accommodating cavity.

In a possible implementation, the auxiliary heat dissipation member includes a bottom plate and a cover plate that are connected to each other to form the auxiliary heat dissipation cavity, a gas intake, and a liquid outtake.

The gas intake is provided on the bottom plate or the cover plate, and is configured to communicate the accommodating cavity with the auxiliary heat dissipation cavity.

The liquid outtake is provided on the bottom plate or the cover plate, and is configured to communicate the auxiliary heat dissipation cavity with the accommodating cavity.

In a possible implementation, the gas intake and the liquid outtake are respectively provided on two opposite sides.

A guiding slope is provided inside the auxiliary heat dissipation cavity, and has a first side extending towards the gas intake, and a second side extending towards the liquid outtake.

An angle between the first side and the second side is an obtuse angle.

In a possible implementation, a plurality of third support members are provided inside the auxiliary heat dissipation cavity. One end of each of the plurality of third support members is connected to the bottom plate, and the other end of the third support member is connected to the cover plate.

The plurality of third support members are distributed in a staggered manner.

In a possible implementation, each of the plurality of third support members is provided with a gas channel passing through the third support member, and the bottom plate and the cover plate are each provided with a through hole at a position corresponding to each of the plurality of third support members. The gas channel is in communication with the corresponding through holes to form a complete gas flow channel.

In a possible implementation, the gas intake is in communication with the accommodating cavity through a gas inlet pipe, and the liquid outtake is in communication with the accommodating cavity through a liquid return pipe.

In a possible implementation, one gas intake and one gas inlet pipe are provided. Alternatively, at least two gas intakes and at least two gas inlet pipes are provided, and the at least two gas inlet pipes are parallel to each other.

In a possible implementation, the heat dissipation substrate, the heat dissipation fin, and the auxiliary heat dissipation member are assembled and soldered or brazed into one piece.

The heat dissipation fin, the thermosiphon heatsink, and the multi-dimensional heat dissipation device according to the present application have at least the following advantages.

In use of the heat dissipation fin according to the present application, the gaseous working medium enters the gas inlet of the heat dissipation fin from the accommodating cavity inside the heat dissipation substrate of the thermosiphon heatsink, and then flows through the first flow guide portion and the connecting portion into the gas-liquid cavity of the shell to perform heat exchange by phase change. After that, the liquid working medium flows through the connecting portion and the second flow guide portion in sequence, is guided by the second flow guide portion, and enters the accommodating cavity inside the heat dissipation substrate of the thermosiphon heatsink through the liquid outlet.

The first flow guide portion has one end in communication with the gas inlet, and the other end in communication with the connecting portion, and is at obtuse angle from the connecting portion, that is, the first flow guide portion is inclined to guide the gaseous working medium. Therefore, the gaseous working medium can flow in through the gas inlet, and flow to the connecting portion through the first flow guide portion more smoothly. In this way, under guiding of the first flow guide portion, the gaseous working medium can flow into the gas-liquid cavity faster.

The second flow guide portion has one end in communication with the liquid outlet, and the other end in communication with the connecting portion, and is at the obtuse angle from the connecting portion, that is, the second flow guide portion is inclined, so that the liquid working medium can flow downwards along the slope to enter the accommodating cavity inside the heat dissipation substrate, thereby guiding the liquid working medium. Therefore, the liquid working medium can flow to the second flow guide portion along the connecting portion, and flow to the liquid outlet more smoothly. In this way, the liquid working medium can flow to the liquid outlet faster along the second flow guide portion, and finally flow back to the accommodating cavity inside the heat dissipation substrate faster.

Therefore, the heat dissipation fin provided in the present application is provided with the first flow guide portion to allow the gaseous working medium to flow into the gas-liquid cavity faster, and is provided with the second flow guide portion to allow the liquid working medium to flow out of the gas-liquid cavity faster. In this way, the working medium flows more smoothly, thereby improving the heat dissipation performance of the heat dissipation fin, and further enhancing the heat dissipation performance of the heatsink.

In summary, the heat dissipation fin provided in the present application can solve the problem of poor circulation of the working medium in the conventional technology, so as to improve the heat dissipation performance of the heatsink.

In addition, the thermosiphon heatsink and the multi-dimensional heat dissipation device according to the present application have the above heat dissipation fin, and therefore have the same advantages as the above heat dissipation fin, which are not repeatedly described herein.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic view showing the structure of a heat dissipation fin according to the present application;
FIG. 2 is an exploded view of a multi-dimensional heat dissipation device according to the present application;
FIG. 3 is a side view of the multi-dimensional heat dissipation device after being assembled;
FIG. 4 is a front view of a heat dissipation substrate; and
FIG. 5 is a front view of an auxiliary heat dissipation member.

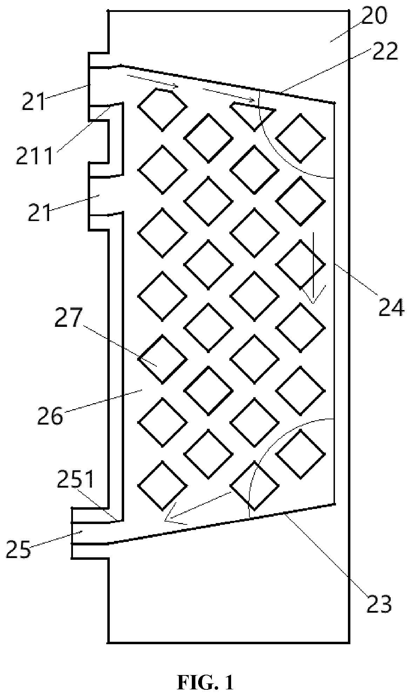

Reference numerals in FIGS. 1 to 5:

| | | | |
|---|---|---|---|
| 1 | heat dissipation substrate, | 11 | accommodating cavity, |
| 12 | second support member, | 2 | heat dissipation fin, |
| 20 | shell, | 21 | gas inlet, |
| 211 | third flow guide portion, | 22 | first flow guide portion, |
| 23 | second flow guide portion, | 24 | connecting portion, |
| 25 | liquid outlet, | 251 | fourth flow guide portion, |
| 26 | gas-liquid cavity, | 27 | first support member, |
| 3 | heat source, | 4 | auxiliary heat dissipation member, |
| 41 | auxiliary heat dissipation cavity, | 42 | bottom plate, |
| 43 | cover plate, | 44 | gas intake, |
| 45 | liquid outtake, | 46 | guiding slope, |
| 47 | third support member, | 5 | gas inlet pipe, |
| 6 | liquid return pipe. | | |

### DETAILED DESCRIPTION OF THE EMBODIMENTS

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

A focus of the present application is to provide a heat dissipation fin, which can solve the problem of poor circulation of a working medium in the conventional technology to improve the heat dissipation performance of a heatsink. Another focus of the present application is to provide a thermosiphon heatsink and a multi-dimensional heat dissipation device that include the heat dissipation fin.

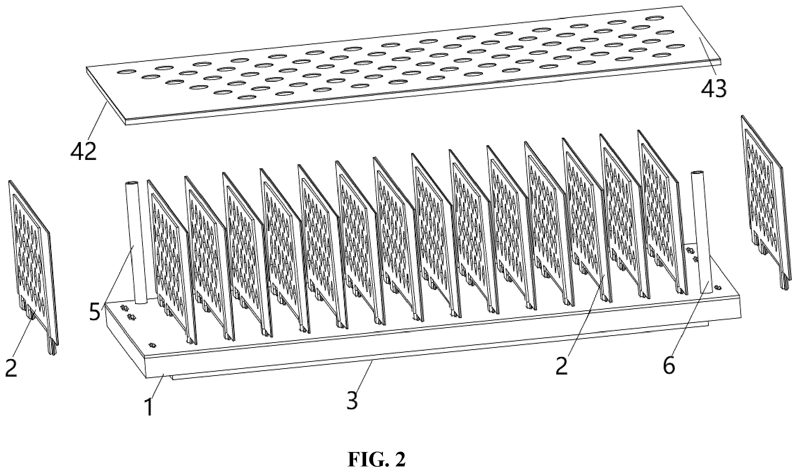

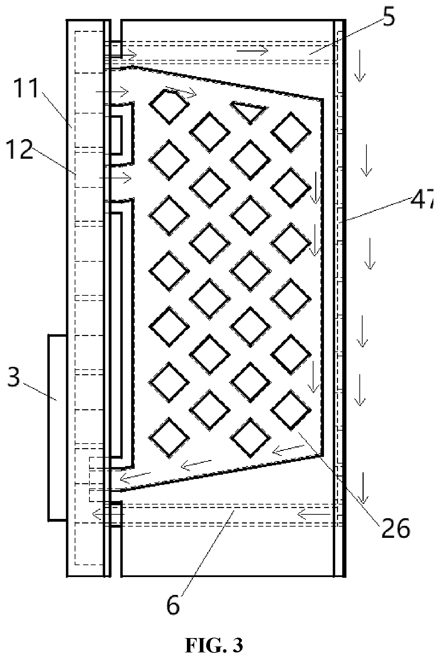

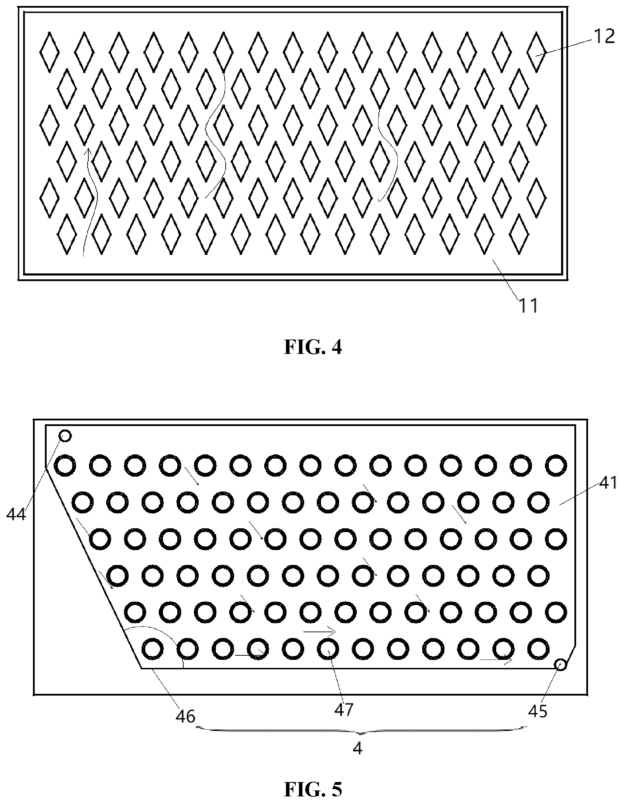

Referring to FIGS. 1 to 5, FIG. 1 is a schematic view showing the structure of a heat dissipation fin according to the present application; FIG. 2 is an exploded view of a multi-dimensional heat dissipation device according to the present application; FIG. 3 is a side view of the multi-dimensional heat dissipation device after being assembled; FIG. 4 is a front view of a heat dissipation substrate; and FIG. 5 is a front view of an auxiliary heat dissipation member.

In a specific embodiment, a heat dissipation fin is provided, which is applied to a thermosiphon heatsink. The heat dissipation fin includes a shell 20, a gas inlet 21 and a liquid outlet 25 that are provided on the shell 20, and a gas-liquid cavity 26 that is provided inside the shell 20. The gas inlet 21 is configured to communicate the gas-liquid cavity 26 with an accommodating cavity 11 inside a heat dissipation substrate 1 of the thermosiphon heatsink, so as to allow a gas inside the accommodating cavity 11 to flow into the gas-liquid cavity 26. The liquid outlet 25 is configured to communicate the gas-liquid cavity 26 with the accommodating cavity 11, so as to allow a liquid inside the gas-liquid cavity 26 to flow into the accommodating cavity 11. The gas inlet 21 is located above the liquid outlet 25 in a vertical direction. The gas-liquid cavity 26 includes a first flow guide portion 22, a second flow guide portion 23, and a connecting portion 24. The first flow guide portion 22 is configured to guide the flow of gas, and is in communication with the gas inlet 21. The second flow guide portion 23 is configured to guide the flow of liquid, and is in communication with the liquid outlet 25. The connecting portion 24 is in communication with the first flow guide portion 22 and the second flow guide portion 23. An angle between the first flow guide portion 22 and the connecting portion 24, and an angle between the connecting portion 24 and the second flow guide portion 23 are both obtuse angles.

In use of the heat dissipation fin according to the present application, the heat dissipation fin is connected to the heat dissipation substrate 1 of the thermosiphon heatsink, and the thermosiphon heatsink is vertically placed in general. The gaseous working medium enters the gas inlet 21 of the heat dissipation fin from the accommodating cavity 11 inside the heat dissipation substrate 1 of the thermosiphon heatsink, and then enters the gas-liquid cavity 26 of the shell 20 along the first flow guide portion 22 and the connecting portion 24 to perform heat exchange by phase change. After that, the liquid working medium passes through the connecting portion 24 and the second flow guide portion 23 in sequence, and is guided by the second flow guide portion 23 to enter the accommodating cavity 11 inside the heat dissipation substrate 1 of the thermosiphon heatsink through the liquid outlet 25.

The first flow guide portion 22 has one end communicated with the gas inlet 21, and the other end communicated with the connecting portion 24, and is at an obtuse angle from the connecting portion 24, that is, the first flow guide portion 22 is inclined to guide the gaseous working medium. Therefore, the gaseous working medium can flow in through the gas inlet 21, and flow to the connecting portion 24 along the first flow guide portion 22 more smoothly. In this way, under the guiding action of the first flow guide portion 22, the gaseous working medium can flow into the gas-liquid cavity 26 faster.

The second flow guide portion 23 has one end communicated with the liquid outlet 25, the other end communicated with the connecting portion 24, and is at an obtuse angle from the connecting portion 24, that is, the second flow guide portion 23 is inclined, so that the liquid working medium can flow downwards along the slope to enter the accommodating cavity 11 inside the heat dissipation substrate 1, thereby guiding the liquid working medium. Therefore, the liquid working medium can flow to the second flow guide portion 23 along the connecting portion 24 and flow to the liquid outlet 25 more smoothly. In this way, the liquid working medium can flow to the liquid outlet 25 faster along the second flow guide portion 23, and finally flow back to the accommodating cavity 11 inside the heat dissipation substrate 1 faster.

Therefore, the heat dissipation fin provided in the present application is provided with the first flow guide portion 22 to allow the gaseous working medium to flow into the gas-liquid cavity 23 more quickly, and is provided with the second flow guide portion 23 to allow the liquid working medium to flow out of the gas-liquid cavity 26 more quickly. In this way, the working medium flows more smoothly, thereby improving the heat dissipation performance of the heat dissipation fin, and further enhancing the heat dissipation performance of the heatsink.

As described above, The heat dissipation fin provided in the present application can solve the problem of poor circulation of the working medium in the conventional technology, so as to improve the heat dissipation performance of the heatsink.

In an embodiment, a third flow guide portion 211 for guiding the flow of gas (i.e. the gaseous working medium) is provided at the gas inlet 21 to guide the gas to flow, and a fourth flow guide portion 251 for guiding the flow of liquid (i.e. the liquid working medium) is provided at the liquid outlet 25 to guide the liquid to flow. The gaseous working medium enters the gas-liquid cavity 26 more smoothly by providing the third flow guide portion 211, and the liquid working medium flows out of the gas-liquid cavity 26 more smoothly by providing the fourth flow guide portion 251.

In an embodiment, a plurality of first support members 27 are provided inside the gas-liquid cavity 26, and two opposite ends of each of the plurality of first support members 27 are connected to the shell 20 to support the shell 20. The first support member 27 is provided with a guiding surface.

It should be noted that, the first support member 27 may be a quadrilateral column. The guiding surface of the first support member 27 can reduce a vaporization resistance of the working medium, such that a vaporization rate and a condensation rate of the working medium tend to be balanced. The first support member 27 can be easily formed by stamping.

Further, the first support member 27 may be a regular square column that is inclined by 45°. After entering into the gas-liquid cavity, the gaseous working medium is divided into two parts by the regular square column, and the two parts of the working medium contact the regular square column to exchange heat, thereby further improving the heat dissipation efficiency and effect of the device.

It should be noted that, the plurality of first support members 27 inside the gas-liquid cavity 26 may be distributed in a staggered manner, such that the working medium flows in a more complicated manner inside the gas-liquid cavity 26. In this way, the working medium can flow through a surface of the plurality of first support members 27 more sufficiently, so as to enlarge the heat exchange area, thereby making the heat transfer and exchange of the working medium more sufficient, and further ensuring the more smooth exchange between the gaseous working medium and the liquid working medium as well as the more sufficient heat dissipation.

In an embodiment, the shell 20 is provided with at least two gas inlets 21, or the shell 20 is provided with a single gas inlet 21 and a single liquid outlet 25.

It should be noted that, an upper portion of the gas-liquid cavity 26 may be provided with at least two gas inlets 21, and a lower portion of the gas-liquid cavity 26 may be provided with a single liquid outlet 25. The working medium has a high pressure and rate during vaporization. With the at least two gas inlets 21 on the upper portion of the gas-liquid cavity 26, the resistance to the working medium during operation can be effectively reduced. Three or more gas inlets 21 may be provided according to characteristics of the device, so as to prevent the device from drying due to an excessive resistance to vaporization of the working medium.

It should be noted that, the gas inlet 21 and the liquid outlet 25 may be distant from each other, rather than close to each other. In this way, relatively large potential difference and pressure difference are formed between the gaseous working medium and the liquid working medium, so that the liquid working medium can flow under a sufficient pressure difference, and the liquid working medium can be prevented from being vaporized and entering the heat dissipation fin 4 through the liquid outlet 25, thereby preventing a resistance to the return flow. For example, a distance between the liquid outlet 25 and the gas inlet 21 adjacent to the liquid outlet 25 is required to be larger than a depth of the liquid working medium, to prevent the liquid working medium from directly entering the gas inlet 21, thereby ensuring the phase change of the working medium to be successful.

In an embodiment, the gas inlet 21 and the liquid outlet 25 are provided at a same side. That is, a section of the gas-liquid cavity is trapezoidal, as shown in FIG. 1, where the working medium flows in a direction indicated by arrows.

In addition to the heat dissipation fin, a thermosiphon heatsink including the heat dissipation fin is further provided according to the present application. The thermosiphon heatsink includes a heat dissipation substrate 1 and a heat dissipation fin 2. An accommodating cavity 11 is provided inside the heat dissipation substrate 1, and is configured to accommodate a phase-change working medium. The heat dissipation fin 2 is connected to the heat dissipation substrate 1, and is the heat dissipation fin according to any one of the above solutions. The accommodating cavity 11 is in communication with the gas inlet 21 and the liquid outlet 25.

In an embodiment, a plurality of second support members 12 are provided inside the accommodating cavity 11. Two opposite ends of each of the plurality of second support members 12 are connected to the heat dissipation substrate 1, and the plurality of second support members 12 are distributed in a staggered manner.

It should be noted that, each second support member 12 may be a rhomboid column, a regular hexagonal column, or an elliptical column. The plurality of second support members 12 inside the accommodating cavity 11 are distributed in a staggered manner. The elliptical column is irregular, and has a same size as the rhomboid column. That is, four sharp corners of the rhomboid column are rounded to form the irregular elliptical column. Besides, each second support member 12 is configured to be the rhomboid column, the regular hexagonal column, or the elliptical column, so as to better reduce the resistance to the vaporization of the working medium, so that the working medium sufficiently flows through the side wall of the second support member 12 to exchange heat.

It should be further noted that, the plurality of second support members 12 are distributed in a staggered manner, so that the working medium flows in a more complicated manner. In this way, the working medium can flow through a surface of the plurality of second support members 12 more sufficiently, so as to enlarge the heat exchange area, thereby making the heat transfer and exchange more sufficient, and further ensuring the more smooth exchange between the gaseous working medium and the liquid working medium as well as the more sufficient heat dissipation.

In addition to the thermosiphon heatsink, a multi-dimensional heat dissipation device including the thermosiphon heatsink is further provided according to the present application. The multi-dimensional heat dissipation device includes the heat dissipation substrate 1 and the heat dissipation fin 2 according to any one of the above solutions, and an auxiliary heat dissipation member 4 that is provided at a side of the heat dissipation fin 2 away from the heat dissipation substrate 1. An auxiliary heat dissipation cavity 41 is provided inside the auxiliary heat dissipation member 4, and the auxiliary heat dissipation cavity 4 is in communication with the accommodating cavity 11.

It should be noted that, generally, the multi-dimensional heat dissipation device is vertically placed in use. With the auxiliary heat dissipation member 4 provided at the side of the heat dissipation fin 2, the multi-dimensional heat dissipation device can perform the heat dissipation in both a horizontal direction and the vertical direction, thereby realizing a multi-dimensional heat dissipation operation. This multi-dimensional heat dissipation method holds enormous promise in the future.

It should be further noted that, only one auxiliary heat dissipation member 4 may be provided. If there is enough space for the device, or if the power consumption increases, multiple auxiliary heat dissipation members 4 may be stacked one above another, and may be in communication with each other, so that the heat exchange can be performed through multiple loops and in multiple dimensions at the same time, thereby effectively enhancing the heat dissipation performance of the device. Moreover, the accommodating cavity 11 and the auxiliary heat dissipation cavity 41 may have different shapes, and are in communication with each other, such that the working medium inside the accommodating cavity 11 can not only enter the heat dissipation fin, but also enter the auxiliary heat dissipation cavity 41 for phase-change heat exchange, which effectively ensures and improves the heat dissipation effect of the device.

In an embodiment, the auxiliary heat dissipation member 4 includes a bottom plate 42 and a cover plate 43 that are connected to each other to form the auxiliary heat dissipation cavity 41, a gas intake 44, and a liquid outtake 45. The gas intake 44 is provided on the bottom plate 42 or the cover plate 43, and is used to communicate the accommodating cavity 11 with the auxiliary heat dissipation cavity 41. The liquid outtake 45 is provided on the bottom plate 42 or the cover plate 43, and is used to communicate the auxiliary heat dissipation cavity 41 with the accommodating cavity 11.

It should be noted that, most of the gaseous working medium is at an upper portion of the auxiliary heat dissipation cavity 41. Therefore, the gas intake 44 may be provided at a top portion of the auxiliary heat dissipation cavity 41, and the liquid outtake 45 may be provided at a bottom portion of the auxiliary heat dissipation cavity 41.

In an embodiment, the gas intake 44 and the liquid outtake 45 are respectively provided at two opposite sides. A guiding slope 46 is provided inside the auxiliary heat dissipation cavity 41. A first side of the guiding slope 46 extends towards the gas intake 44, and a second side of the guiding slope 46 extends towards the liquid outtake 45. An angle between the first side and the second side is an obtuse angle. That is, the guiding slope 46 is provided inside the auxiliary heat dissipation cavity 41 to guide the flow of the working medium, such that the phase change of the working medium can occur more smoothly. The directions of arrows in the drawings represent a flowing direction of the working medium.

In an embodiment, a plurality of third support members 47 are provided inside the auxiliary heat dissipation cavity 41. One end of each of the plurality of third support members 47 is connected to the bottom plate 42, and the other end of the third support member 47 is connected to the cover plate 43, which facilitates the processing and manufacturing of the plurality of third support members 47 inside the auxiliary heat dissipation cavity 41 in a large scale.

The plurality of third support members 47 are distributed in a staggered manner, so that the working medium flows in a more complicated manner inside the auxiliary heat dissipation cavity 41. In this way, the working medium can flow through a surface of the plurality of third support members 47 more sufficiently, so as to enlarge the heat exchange area, thereby making the heat transfer and exchange of the working medium more sufficient, and further ensuring the more smooth transition between the gaseous working medium and the liquid working medium as well as the more sufficient heat dissipation.

In an embodiment, each of the plurality of third support members 47 is provided with a gas channel passing through the third support member 47. The bottom plate 42 and the cover plate 43 are each provided with a through hole at a position in correspondence to each of the plurality of third support members 47. The gas channel is in communication with the corresponding through hole to form a complete gas flow channel, and air can flow through the gas flow channel.

It should be noted that, the hot air between the heat dissipation fins can flow out through the gas flow channel to form a concentrated convection to accelerate the air exchange, which further improves the heat dissipation performance.

In an embodiment, the gas intake 44 is in communication with the accommodating cavity 11 through a gas inlet pipe 5, and the liquid outtake 45 is in communication with the accommodating cavity 11 through a liquid return pipe 6.

It should be noted that, the heat dissipation substrate 1 may be provided with at least two slots that are configured to accommodate the heat dissipation fins 2. In this way, multiple heat dissipation fins 2 are arranged on the heat dissipation substrate 1 in sequence. Moreover, the multiple heat dissipation fins 2 are evenly spaced apart from each other to facilitate the processing and manufacturing in a large scale. Besides, the gas inlet pipe 5 and the liquid return pipe 6 may be provided between two adjacent heat dissipation fins 2.

For example, the gas inlet pipe 5 and the liquid return pipe 6 may be respectively provided between two outermost heat dissipation fins 2 and the heat dissipation fins 2 adjacent to the two outermost heat dissipation fins 2, such that the gas inlet pipe 5 and the liquid return pipe 6 are respectively located at two ends of the heat dissipation substrate 1, to extend a flow path of the phase-change working medium inside the cavity of the top plate, thereby further improving the heat dissipation effect of the device. Certainly, positions of the gas inlet pipe 5 and the liquid return pipe 6 may be determined according to practice.

In an embodiment, a single gas intake 44 and a single gas inlet pipe 5 are provided. Or, at least two gas intakes 44 and at least two gas inlet pipes 5 are provided, and the at least two gas inlet pipes 5 are distributed to be parallel to each other. The working medium has a high pressure and rate during vaporization. With the one or more gas inlet pipes 5 provided between the accommodating cavity 11 and the auxiliary heat dissipation cavity 41, the resistance to the operation of the working medium can be reduced.

In an embodiment, the heat dissipation substrate 1, the multiple heat dissipation fins 2, and the auxiliary heat dissipation member 4 are integrally formed by brazing after being assembled.

It should be noted that, the multiple heat dissipation fins 2 are inserted into the heat dissipation substrate 1, and then the auxiliary heat dissipation member 4 is fixed to the multiple heat dissipation fins 2. After all the components are assembled, i.e. after the heat dissipation substrate 1, the multiple heat dissipation fins 2, and the auxiliary heat dissipation member 4 are assembled to form a whole structure, the whole structure is brazed in a tunnel furnace to form an integrated brazing structure, i.e. to be integrally formed by brazing. The heat can be directly conducted from the heat dissipation fins 2 to the auxiliary heat dissipation cavity 41, which significantly improves the heat exchange efficiency of the heat dissipation fins 2. Moreover, the auxiliary heat dissipation cavity 41 is in communication with the accommodating cavity 11 through the gas inlet pipe 5 and the liquid return pipe 6, so that the multi-dimensional heat dissipation can be achieved by the accommodating cavity 11, the heat dissipation fins 2, and the auxiliary heat dissipation cavity 41, thereby effectively enhancing the heat dissipation efficiency of the device.

To further describe the method of use of this device, an example is provided hereinafter. A heat source 3 may be provided at a side of the heat dissipation substrate 1. For example, the heat source 3 is affixed to a side of the heat dissipation substrate 1 opposite to the heat dissipation fins 2.

When being powered, the heat source 3 operates and produces a heat. The phase-change working medium inside the accommodating cavity 11 absorbs the heat coming from the heat source 3 and is vaporized into the gaseous working medium. The gaseous working medium enters the gas inlet 21 of the heat dissipation fins 2 from the accommodating cavity 11, and then enters the gas-liquid cavity 26 along the first flow guide portion 22 to perform heat exchange by phase change. After that, the liquid working medium passes through the connecting portion 24 and the second flow guide portion 23 in sequence, is guided by the second flow guide portion 23, and returns to the accommodating cavity 11 through the liquid outlet 25.

It should be noted that, the distance between the gas inlet 21 and the liquid outlet 25 is large, thus, a relatively large potential difference and pressure difference are formed between the gaseous working medium and the liquid working medium, so that the liquid working medium can flow under a sufficient pressure difference, and the liquid working medium can be prevented from being vaporized and entering the heat dissipation fin 2 through the liquid outlet 25 to form a resistance to the return flow.

Similarly, when the heat source 3 is powered, a part of the gaseous working medium enters the auxiliary heat dissipation cavity 41 through the gas inlet pipe 5 at the same time. Guided by the slope structure, the liquid working medium enters the accommodating cavity 11 through the liquid return pipe 6. The operation principle of this device is shown in FIG. 3, where the working medium flows in a direction indicated by arrows. Since the support members (i.e. the heat dissipation columns) inside the accommodating cavity 11 and inside the auxiliary heat dissipation cavity 41 are all distributed in a staggered manner, and the support members in different cavities have different structures, the flow channels formed inside the accommodating cavity 11 and inside the auxiliary heat dissipation cavity 41 both can help the working medium exchange heat evenly.

In addition, the bottom plate 42 and the cover plate 43 are connected to each other to form the auxiliary heat dissipation cavity 41, and the auxiliary heat dissipation cavity 41 may be hollowed out, which produces a good chimney effect to make the hot air to convect in a concentrated manner. Moreover, the phase-change working medium is provided inside the auxiliary heat dissipation cavity 41, so that the auxiliary heat dissipation cavity 41 can also perform phase-change heat exchange with the working medium thereinside in addition to receiving the heat conducted from the heat dissipation fins 2.

Furthermore, the support members (i.e. the heat dissipation columns) of the accommodating cavity 11, the auxiliary heat dissipation cavity 41, and the gas-liquid cavity 26 have special structures that are designed according to phase change principle of the working medium, and the slope structure and guiding structure inside each cavity have a great guiding effect. Complicated heat exchange can be performed in different directions inside each cavity. The accommodating cavity 11 is in direct communication with the auxiliary heat dissipation cavity 41, and the phase-change heat exchange is performed in both cavities at the same time. Therefore, the multi-dimensional heat dissipation method of this device is very promising in the future, and can effectively satisfy the heat dissipation demand of high power consuming communication devices in the future.

It should be noted that, the terms "first", "second", and "third" in the first flow guide portion 22 and the second flow guide portion 23, the first side and the second side, and the first support members 27, the second support members 12, and the third support members 47 mentioned herein are merely intended to distinguish different positions thereof, and do not indicate any order.

In addition, it should be noted that, the orientation or positional relationship indicated by the terms "inlet", "outlet", etc. are based on those shown in the accompanying drawings, and are merely for the convenience of simplifying the description and understanding the present application. They do not indicate or imply that the apparatus or element referred to must have a specific orientation, or be constructed and operated in a specific orientation, and therefore should be understood as a limitation to the present application.

The above embodiments in this specification are described in a progressive manner. Each of the embodiments is mainly focused on describing its differences from other embodiments, and references may be made among these embodiments with respect to the same or similar portions among these embodiments. Any combination of all the embodiments of the present application is deemed to fall into the scope of protection of the present application, which is not described in detail herein.

The heat dissipation fin, the thermosiphon heatsink, and the multi-dimensional heat dissipation device according to the present application are described hereinabove. The principle and the embodiments of the present application are illustrated herein by specific examples. The above descriptions of examples are only intended to help the understanding of the method and the main idea of the present application. It should be noted that, for those skilled in the art, a few of modifications and improvements may be made to the present application without departing from the principle of the present application, and these modifications and improvements are also deemed to fall into the scope of the present application defined by the claims.

## Claims

1. A heat dissipation fin, applied to a thermosiphon heatsink, and comprising a shell (20), a gas inlet (21) and a liquid outlet (25) that are provided in the shell (20), and a gas-liquid cavity (26) that is provided inside the shell (20), wherein
the gas inlet (21) is configured to communicate the gas-liquid cavity (26) with an accommodating cavity (11) inside a heat dissipation substrate (1) of the thermosiphon heatsink, to allow a gas inside the accommodating cavity (11) to flow into the gas-liquid cavity (26);
the liquid outlet (25) is configured to communicate the gas-liquid cavity (26) with the accommodating cavity (11), to allow a liquid inside the gas-liquid cavity (26) to flow into the accommodating cavity (11);
the gas inlet (21) is located above the liquid outlet (25) in a vertical direction; and
the gas-liquid cavity (26) comprises a first flow guide portion (22), a second flow guide portion (23), and a connecting portion (24); wherein
the first flow guide portion (22) is configured to guide flow of the gas, and is in communication with the gas inlet (21);
the second flow guide portion (23) is configured to guide flow of the liquid, and is in communication with the liquid outlet (25);
the connecting portion (24) is in communication with the first flow guide portion (22) and the second flow guide portion (23); and
an angle between the first flow guide portion (22) and the connecting portion (24), and an angle between the connecting portion (24) and the second flow guide portion (23) are both obtuse angles.

2. The heat dissipation fin according to claim 1, wherein a third flow guide portion (211) is provided at the gas inlet (21) and is configured to guide flow of the gas, and a fourth flow guide portion (251) is provided at the liquid outlet (25) and is configured to guide flow of the liquid.

3. The heat dissipation fin according to claim 1, wherein a plurality of first support members (27) are provided inside the gas-liquid cavity (26), two opposite ends of each of the plurality of first support members (27) are connected to the shell (20), and each first support member (27) is provided with a guiding surface.

4. The heat dissipation fin according to claim 1, wherein the shell (20) is provided with at least two gas inlets (21), or the shell (20) is provided with a single gas inlet (21) and a single liquid outlet (25).

5. The heat dissipation fin according to claim 1, wherein the gas inlet (21) and the liquid outlet (25) are provided at a same side.

6. A thermosiphon heatsink, comprising a heat dissipation substrate (1), and the heat dissipation fin (2) according to any one of claims 1 to 5, wherein
an accommodating cavity (11) is provided inside the heat dissipation substrate (1), and is configured to accommodate a phase-change working medium;
the heat dissipation fin (2) is connected to the heat dissipation substrate (1); and
the accommodating cavity (11) is in communication with the gas inlet (21) and the liquid outlet (25).

7. The thermosiphon heatsink according to claim 6, wherein a plurality of second support members (12) are provided inside the accommodating cavity (11), two opposite ends of each of the plurality of second support members (12) are connected to the heat dissipation substrate (1), and the plurality of second support members (12) are distributed in a staggered manner.

8. A multi-dimensional heat dissipation device, comprising the heat dissipation substrate (1) and the heat dissipation fin (2) according to any one of claims 6 to 7, and an auxiliary heat dissipation member (4) that is provided at a side of the heat dissipation fin (2) opposite to the heat dissipation substrate (1), wherein an auxiliary heat dissipation cavity (41) is provided inside the auxiliary heat dissipation member (4), and is in communication with the accommodating cavity (11).

9. The multi-dimensional heat dissipation device according to claim 8, wherein
the auxiliary heat dissipation member (4) comprises a bottom plate (42), a cover plate (43), a gas intake (44), and a liquid outtake (45); wherein
the bottom plate (42) and the cover plate (43) are connected to each other to form the auxiliary heat dissipation cavity (41);
the gas intake (44) is provided in the bottom plate (42) or the cover plate (43), and is configured to communicate the accommodating cavity (11) with the auxiliary heat dissipation cavity (41); and
the liquid outtake (45) is provided in the bottom plate (42) or the cover plate (43), and is configured to communicate the auxiliary heat dissipation cavity (41) with the accommodating cavity (11).

10. The multi-dimensional heat dissipation device according to claim 9, wherein
the gas intake (44) and the liquid outtake (45) are respectively provided on two opposite sides;
a guiding slope (46) is provided inside the auxiliary heat dissipation cavity (41), has a first side extending towards the gas intake (44), and a second side extending towards the liquid outtake (45); and
an angle between the first side and the second side is an obtuse angle.

11. The multi-dimensional heat dissipation device according to claim 9, wherein
a plurality of third support members (47) are provided inside the auxiliary heat dissipation cavity (41), and each have one end connected to the bottom plate (42), and the other end connected to the cover plate (43); and
the plurality of third support members (47) are distributed in a staggered manner.

12. The multi-dimensional heat dissipation device according to claim 11, wherein each of the plurality of third support members (47) is provided with a gas channel passing through the third support member (47), the bottom plate (42) and the cover plate (43) are each provided with a through hole at a position corresponding to each of the plurality of third support members (47), and the gas channel is in communication with the corresponding through holes to form a complete gas flow channel.

13. The multi-dimensional heat dissipation device according to any one of claims 9 to 12, wherein the gas intake (44) is in communication with the accommodating cavity (11) through a gas inlet pipe (5), and the liquid outtake (45) is in communication with the accommodating cavity (11) through a liquid return pipe (3).

14. The multi-dimensional heat dissipation device according to claim 13, wherein
a single gas intake (44) and a single gas inlet pipe (5) are provided; or
at least two gas intakes (44) and at least two gas inlet pipes (5) are provided, and the at least two gas inlet pipes (5) are parallel to each other.

15. The multi-dimensional heat dissipation device according to any one of claims 8 to 12, wherein the heat dissipation substrate (1), the heat dissipation fin (2), and the auxiliary heat dissipation member (4) are assembled, and soldered or brazed into one piece.
